# EUROPEAN PATENT SPECIFICATION

(11) **EP 0 324 244 B1**
(45) Date of publication and mention of the grant of the patent: **30.11.1994**
(21) Application number: 88311767.3
(22) Date of filing: 13.12.1988
(51) Int. Cl.: H01L 23/64, H01L 23/498, H01L 21/60

(54) **Tape automated bonding package for a semiconductor chip with decoupling**
Automatische Bandmontagen-Packung für einen Halbleiterchip mit Entkupplung
Empaquetage à transport automatique sur bande pour une puce semi-conductrice comprenant du découplage

(30) Priority: 15.01.1988 US 145808
(43) Date of publication of application: 19.07.1989
(73) Proprietor: International Business Machines Corporation, Armonk, N.Y. 10504 (US)
(72) Inventor: Frankeny, Richard Francis, Elgin Texas 78621 (US); Rakes, James Mitchell, Leander Texas 78641 (US)
(74) Representative: Burt, Roger James, Dr.

(56) References cited:
- DE-A- 3 616 494
- ELECTRONICS INTERNATIONAL, vol. 55, no. 14, July 1982, pages 45-46, New York, US; J. LYMAN: "Densest chip-package packs leads onto 12.5-mil centers"
- IBM TECHNICAL DISCLOSURE BULLETIN, vol. 31, no. 1, June 1988, pages 2-4, Armonk, New York, US: "Film on metal leaded chip carrier"

## Description

The present invention relates to improvements in tape automated bonding (TAB) packaging for semiconductor chip devices.

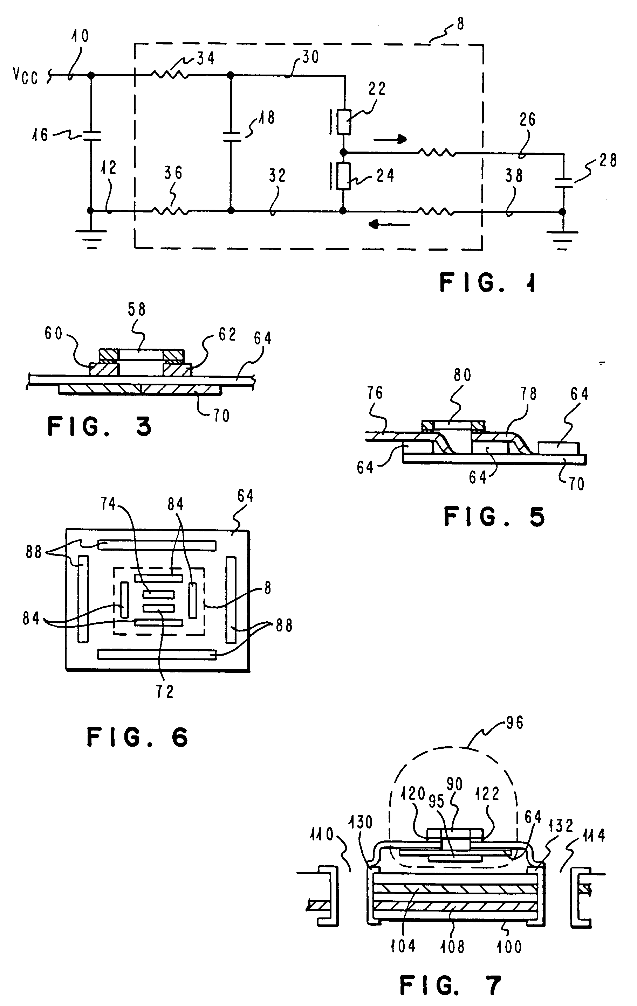

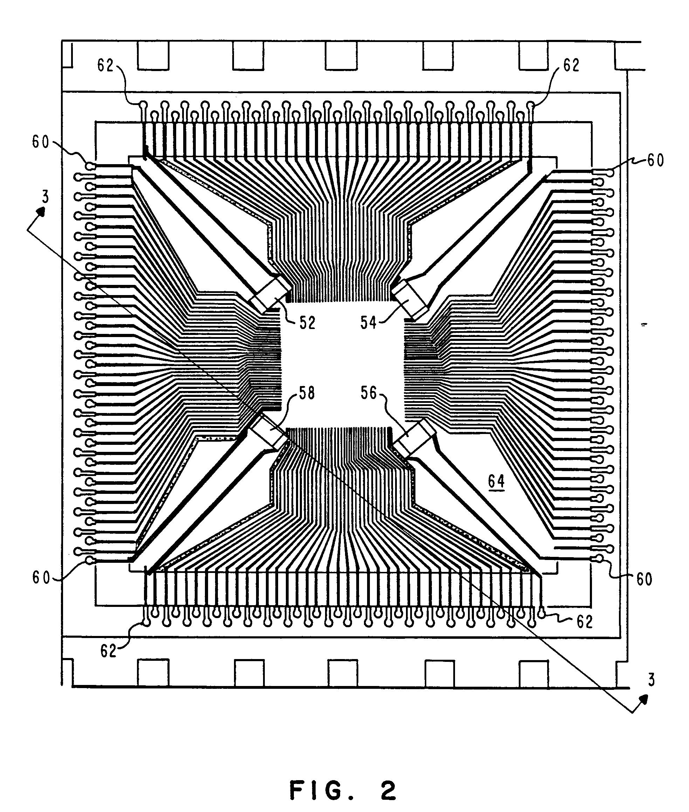

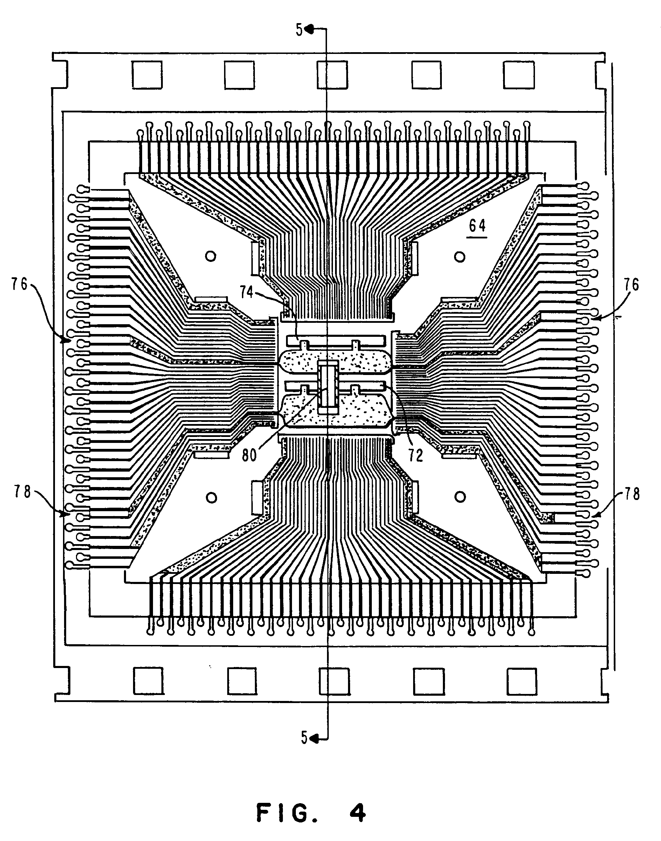

Conventional TAB packaging is well known in the art. Typically, a polymer film web for eventual storage on a reel-like device is provided with evenly spaced apertures. Using conventional techniques, conductive lines are supplied around each aperture with their ends cantilevered into the aperture. These ends are subsequently attached as appropriate to a semiconductor device, one per aperture, as for example shown in U. S. Patent 3,887,783 , Fig. 1. Similar structures are shown in Japanese patent abstracts 0046572 and 125637.

TAB packages generally enable packaging of chips with a high number of I/O connections and can be easily automated for mass handling. However, such a package has higher inductance in connecting leads than corresponding prior art connection technologies such as pin grid array packaging.

IBM Technical Disclosure Bulletin, Vol. 28, No. 7, December, 1985, page 2827, relates to low inductance decoupling capacitor connection and discloses placing a capacitor on a module at each corner of the chip.

U. S. Patent 4,577,214 to Schaper discloses a semiconductor package with low inductance power/ground leads in the package and uses a capacitor. Similarly, U.S. Patent 4,598,307 recognises the need for mounting a bypass capacitor as close as possible to an integrated circuit chip and uses specific unused real estate area of a dual in-line package for mounting a capacitor.

U. S. Patent 4,539,472 discloses interconnecting a plurality of TAB devices as opposed to the conventional technique of having one logic chip within a frame of the tape. Additionally, means are disclosed for connecting apparently from the underside of the active integrated circuit chip device to a lead pattern formed on a substantially rigid substrate.

J Lyman, Electronics International (New York), Vol 55, No 14 (1982) pages 45 and 46, discloses the use of decoupling capacitors in the context of a semiconductor package including a lead frame which is bonded to a ceramic substrate.

The present invention relates to a TAB package for integrated circuits and provides means for offsetting the negative characteristic of high lead inductance by using the polymer layer of a TAB package to support one or more capacitors across power and ground leads going to the chip.

Inductance of the power and ground leads on a TAB package cause voltage drop across the leads to the package when high switched current (di/dt) is applied due to large numbers of simultaneous switching drivers (SSD) or large numbers of internal gates. This characteristic of a TAB package would otherwise limit its use in high performance applications and require a much more expensive package. The present invention avoids going to a more expensive package by utilising the polymer layer of a TAB package to support capacitors close to the chip across the power and ground leads.

According to the invention, there is provided a tape automated bonding package comprising a semiconductor chip mounted on an electrically insulating polymer layer, and a pattern of electrical leads on the layer, including signal, ground and power leads, for interconnecting the semiconductor chip to a printed circuit substrate, characterised by a surface mounted decoupling capacitor directly connected to a ground and to a power lead on the polymer layer, so that the capacitor is supported by the polymer layer, wherein the capacitor lies on the opposite side of the layers to the chip at least partially within an area of the polymer layer defined by the footprint of the chip and in which said layer includes a plurality of apertures for passing leads on the layer, in an area of the layer defined by a footprint of the chip, through to connections on the chip, two of said apertures connecting ground and power leads in said area to the underside of the chip, said capacitor being connected directly to said ground and power leads in said area.

Preferred embodiments of the invention will now be described, by way of example, with reference to the accompanying drawings, in which:-
Figure 1 is a circuit diagram illustrating the basic concept of the present invention;
Figure 2 is a plan view of a TAB package with surface mountable capacitors mounted on the polymer layer;
Figure 3 is cross-sectional view of Figure 2 taken along line 3-3;
Figure 4 is a plan view of capacitors mounted on the polymer layer so as to enable an array of I/O connections to the integrated circuit chip;
Figure 5 is a cross-sectional view taken along line 5-5 of Figure 4;
Figure 6 illustrates a configuration of openings in the polymer layer of a TAB package;
Figure 7 schematically illustrates electrical connection of a TAB package to a multi plane printed circuit card.

Figure 1 shows a circuit illustrating a function performed by capacitors in the TAB package of the invention. An integrated circuit chip device 8, is represented in phantom. Power lead 10 and ground lead 12 connect chip device 8 and a printed circuit board (not shown). A capacitor 16 is mounted across power line 10 and ground line 12.

A second capacitor 18 supplies transient current to drive the load thereby greatly reducing the voltage drop across the device leads. Capacitor 18 may be either surface mounted chips or film capacitors directly connected to the polymer layer (not shown) of the TAB package. Complementary drivers 22 and 24, which may be drive transistors or FETS, represent an output-off-chip device driver stage. Signal line 26 goes to an off chip load represented by capacitor 28. Logic preceding drivers 22 and 24 is not shown. The on-chip power bus represented at 30 and 32 feeds a number of driver stages of which 22 and 24 represent only one. When a number of simultaneous drivers switch, transient current is supplied by capacitor 18, thereby reducing the voltage drop across TAB lead inductance 34, 36.

Since the inductance of the on-chip bus 30, 32 is much less than 34, 36, the voltage transients are minimised. Signal line 26 is a single TAB signal lead feeding an off chip load (capacitor 28). A return ground lead 38 may support more than a single signal lead. The inductance of leads and the transients thus produced are not affected by the packaging concept of this invention; only the inductance 34, 36 of input buses 10 and 12 which carry the current of many drivers, is neutralised.

Figure 2 shows a TAB package viewed from the side opposite to which a semiconductor chip is attached. Four capacitors 52, 54, 56 and 58 are shown mounted across the power 60 and ground 62 lines formed by conventional technology on flexible insulating polymer 64 at each corner. Placing the power input leads 60, 62 parallel and close together, minimises the effective inductance of the TAB lead by cancelling flux and provides a lower impedance path back to a capacitor (16, Fig. 1) on a printed circuit card.

Figure 3 is a cross-sectional view of Figure 2 taken along line 3-3 and shows capacitor 58, power and ground lines 60 and 62, polymer film 64 and a corner of an active integrated circuit device 70.

Figure 4 is a plan view, again from the side of the TAB package opposite that on which the active integrated circuit device is mounted. This arrangement allows chip designers to place power leads in an array format on the underside of a chip 70 (not visible) as opposed to the conventional restriction of having all power leads connect on the periphery of the chip device. Openings 72 and 74 in polymer layer 64 allow connections from power input 76 and ground 78 lines to the chip. A capacitor 80 is mounted across power and ground lines 76 and 78 as described above with reference to Fig. 2.

Figure 5 shows a cross-sectional view of Figure 4 taken along the line 5-5 and shows integrated circuit chip device 70, portions of polymer film layer 64, ground 78 and power 76 lines connected to chip 70. Capacitor 80 is mounted across power and ground lines, 76 and 78 respectively. Such an arrangement enhances conventional TAB packaging technology by allowing internal connections to the chip, that is, to areas of the chip internal to its periphery. Further, such an arrangement as shown in Figures 4 and 5 provides a package which may be electrically tailored to the semiconductor device by the designer who may require voltage and ground attachments in the centre of the chip.

This arrangement allows for voltage and ground to enter a TAB chip device from the sides a shown in Fig. 4 or from the corners. Since a larger contact area is available over the chip, larger decoupling capacitors may be used. By bringing a bus in on the corners, (illustration not shown on Fig. 4) lower inductance inputs are possible without utilising the signal wiring area.

Figure 6 is a schematic plan view of a portion of polymer film 64 in the package shown in Fig. 5. The "footprint" of an integrated circuit chip device 8 is indicated in phantom. In addition to openings 72 and 74 shown in Fig. 5 for permitting internal power and ground connections to a chip, four peripheral openings 84 are shown at which conventional electrical connections are made between the chip and inner lead conductors (not shown) formed on polymer film 64. Openings 88 are provided for permitting electrical interconnection of the outer leads, ends of conductors formed on polymer film 64 and conductive lands on the surface of a printed circuit card substrate.

Figure 7 schematically illustrates the connection of a decoupling capacitor 90 similar to 58 in Fig. 3 or 80 in Fig. 5 to the internal planes of a circuit board on which a TAB device indicated generally at 96 and including integrated circuit device 95 embodying the present invention is mounted. A printed circuit board 100 includes an internal power plane 104 and a ground plane 108. Plated through holes 110, 114 are also provided. Capacitor 90 is connected to conductive lands 120 and 122 of the TAB package. Lands 130 and 132 are on the surface of polymer film 64.

Clearly, the drawing figures are provided for illustrative purposes only, and those having skill in the art will understand the actual arrangement of power and ground lines and placement of capacitors is a function of the integrated circuit chip device design and intended function.

## Claims

1. A tape automated bonding package for a semiconductor chip comprising a semiconductor chip (70, 95) mounted on an electrically insulating polymer layer (64), and a pattern of electrical leads on the layer, including signal (26), ground (62, 78) and power (60, 76) leads, for interconnecting the semiconductor chip (70) to a printed circuit substrate, characterised by a surface mounted decoupling capacitor (52, 54, 56, 58, 80, 90) directly connected to a ground (62, 78) and to a power (60, 76) lead on the polymer layer (64), so that the capacitor is supported by the polymer layer, wherein the capacitor lies on the side of the layer (64) opposite to the chip and at least partially within an area of the polymer layer defined by the footprint (8) of the chip and in which said layer (64) includes a plurality of apertures (72, 74, 84) for passing leads on the side of the layer opposite to the chip, in an area of the layer defined by a footprint (8) of the chip, through to connections on the chip, two of said apertures (72, 74) connecting ground and power leads in said area to the underside of the chip, said capacitor (52, 54, 56, 58, 80, 90) being connected directly to said ground and power leads in said area.

2. A package according to claim 1 in which the semiconductor chip (70) is rectangular and which includes a ground (62) and a power (60) lead positioned on the layer (64) as a pair of adjacent leads passing to a corner area on the chip, said decoupling capacitor (52, 54, 56, 58) being connected to the leads in the pair at a position adjacent to said corner area of the chip (70).

3. A package according to claim 2 including three further pairs of adjacent ground (62) and power (60) leads, each pair being attached to the chip (70) at an associated corner area thereof, and each pair having an associated decoupling capacitor (52, 54, 56, 58) connected thereto at a position adjacent to the corner area associated with that pair.

## Patentansprüche

1. Durch automatisches Filmbonden gefertigte Baugruppe für einen Halbleiterchip das einen Halbleiterchip (70, 95), der auf einer elektrisch isolierenden Polymerschicht (64) angebracht ist, und ein Muster elektrischer Leitungen auf der Schicht, das Signalleitungen (26), Masseleitungen (62, 78) und Stromzuführungsleitungen (60, 76) enthält, zum Verbinden des Halbleiterchips (70) mit dem Substrat einer gedruckten Schaltung umfaßt, gekennzeichnet durch einen an der Oberfläche angebrachten Entkopplungskondensator (52, 54, 56, 58, 80, 90), der direkt mit einer Masseleitung (62, 78) und mit einer Stromzuführungsleitung (60, 76) auf der Polymerschicht (64) verbunden ist, so daß der Kondensator von der Polymerschicht getragen wird, wobei der Kondensator auf der Seite der Schicht (64), die dem Chip gegenüberliegt, und zumindest teilweise innerhalb einer Fläche der Polymerschicht liegt, die durch den Fußabdruck (8) des Chips definiert ist, und in der die Schicht (64) eine Mehrzahl von Öffnungen (72, 74, 84) zum Durchführen von Leitungen auf der dem Chip gegenüberliegenden Seite der Schicht zu Verbindungsanschlüssen auf dem Chip in einer Fläche der Schicht enthält, die durch einen Fußabdruck (8) des Chips definiert wird, wobei zwei dieser Öffnungen (72, 74) die Masse- und Stromzuführungsleitungen in der Fläche mit der Unterseite des Chips verbinden, wobei der Kondensator (52, 54, 56, 58, 80, 90) direkt mit den Masse- und Stromzuführungsleitungen in dieser Fläche verbunden ist.

2. Baugruppe nach Anspruch 1, in welcher der Halbleiterchip (70) rechteckig ist und welche eine Masseleitung 62 und eine Stromzuführungsleitung 60 enthält, die auf der Schicht (64) als ein Paar benachbarter Leitungen angeordnet sind, die zu einer Eckfläche auf dem Chip führen, wobei der Entkopplungskondensator (52, 54, 56, 58) mit den Leitungen des Paares an einer Position verbunden ist, die an die Eckfläche des Chips (70) angrenzt.

3. Baugruppe nach Anspruch 2, die drei weitere Paare benachbarter Masseleitungen (62) und Stromzuführungsleitungen (60) enthält, wobei jedes Paar an den Chip (70) an einer zugeordneten Eckfläche desselben angeschlossen ist und einen ihr zugeordnete Entkopplungskondensator (52, 54, 56, 58) aufweist, der an einer Position angeschlossen ist, die an die dem Paar zugeordnete Eckfläche angrenzt.

## Revendications

1. Boîtier de liaison automatisé à bande pour une puce semiconductrice comprenant une puce semiconductrice (70, 95) montée sur une couche (64) de matière polymère isolante électriquement, et un motif de conducteurs électriques sur la couche, comprenant des conducteurs de signal (26), de masse (62, 78) et de puissance (60, 76), pour interconnecter la puce semiconductrice (70) à un substrat de circuit imprimé, caractérisé par un condensateur de découplage monté en surface (52, 54, 56, 58, 80, 90) directement relié à un conducteur de masse (62, 78) et à un conducteur de puissance (60, 76) sur la couche de matière polymère (64), de telle sorte que le condensateur est supporté par la couche de matière polymère, le condensateur se trouvant sur le côté de la couche (64) opposé à la puce et au moins partiellement à l'intérieur d'une zone de la couche de polymère définie par l'emplacement (8) de la puce et dans lequel ladite couche (64) comporte une pluralité d'ouvertures (72, 74, 84) pour laisser passer les conducteurs sur le côté de la couche opposé à la puce dans une zone de la couche définie par un emplacement (8) de la puce, par l'intermédiaire de connexions sur la puce, deux desdites ouvertures (72, 74) reliant les conducteurs de masse et de puissance dans ladite zone au dessous de la puce, ledit condensateur (52, 54, 56, 58, 80, 90) étant connecté directement auxdits conducteurs de masse et de puissance dans ladite zone.

2. Boîtier selon la revendication 1 dans lequel la puce semiconductrice (70) est rectangulaire et comporte un conducteur de masse (62) et de puissance (60) disposés sur la couche (64) comme une paire de conducteurs adjacents passant dans une zone d'angle sur la puce, ledit condensateur de découplage (52, 54, 56, 58) étant connecté aux conducteurs de la paire en une position adjacente à ladite zone d'angle de la puce (70).

3. Boîtier selon la revendication 2 comportant trois autres paires de conducteurs adjacents de masse (62) et de puissance (60), chaque paire étant fixée à la puce (70) dans un de ses angles associés, et chaque paire ayant un condensateur de découplage associé (52, 54, 56, 58) connecté à celle-ci en une position adjacente à la zone d'angle associée à cette paire.
